# DEMANDE DE BREVET EUROPEEN

(11) **EP 4 617 509 A1**
(43) Date de publication de la demande: **17.09.2025**
(21) Numéro de dépôt: 25163673.4
(22) Date de dépôt: 13.03.2025
(51) Int. Cl.: F16B 5/02, F16B 37/12, H05K 7/20, F28F 3/08, H01L 23/40, H01L 23/473

(54) **DISPOSITIF DE REFROIDISSEMENT POUR UN MODULE DE PUISSANCE**

(30) Priorité: 14.03.2024 FR 2402541
(71) Demandeur: Valeo eAutomotive Germany GmbH, 91056 Erlangen (DE)
(72) Inventeur: CHINNATHAMBI, Gowardanan, 94046 Créteil Cedex (FR); GUERIN, Fabien, 94046 Créteil Cedex (FR); GONCALVES-DA-COSTA, Ricardo, 94046 Créteil Cedex (FR)
(74) Mandataire: Valeo Powertrain Systems

(57) **Abrégé**

L'invention concerne un dispositif de refroidissement (10) pour un module de puissance (20) comportant une partie de circulation (11) dans laquelle un fluide de refroidissement est destiné à circuler et une partie de fixation (12) pour fixer le module de puissance sur la partie de circulation, dans lequel:
- la partie de circulation comporte un empilement (13) de plaques de métal (141, 142, 143),- la partie de fixation (12) comporte un couvercle (17) pour maintenir le module de puissance (20) contre la première plaque (141) de l'empilement (13), et au moins un organe de fixation (18) comportant un filetage, le couvercle (17) étant muni d'un orifice de passage (19) adapté à être positionné en regard d'une ouverture d'accueil (30) de la partie de circulation (11),
ladite ouverture d'accueil (30) de la partie de circulation (11) étant délimitée par un trou central (32) d'un insert fileté (33).

## Description

### Domaine technique

L'invention concerne un dispositif de refroidissement d'un module de puissance.

### Arrière-plan technologique

On connait de l'état de la technique des systèmes électriques et notamment des onduleurs comportant des modules de puissance. Ces modules de puissance sont de préférence associés à un dispositif de refroidissement destiné à empêcher l'échauffement de chaque module de puissance afin de garantir un fonctionnement optimal de celui-ci. Le dispositif de refroidissement comporte typiquement une partie de circulation d'un fluide de refroidissement contre laquelle le module de puissance est appliqué.

Le dispositif de refroidissement comprend un couvercle qui maintient le module de puissance contre la partie de circulation du dispositif de refroidissement, le couvercle étant lui-même fixé par exemple par vissage sur la partie de circulation du dispositif de refroidissement.

Le couvercle et la partie de circulation du dispositif de refroidissement comportent à cet effet un orifice de passage d'une vis de fixation.

La création de cet orifice constitue une étape longue et fastidieuse dans la production du dispositif de refroidissement. L'orifice doit en effet être fileté pour coopérer avec la vis de fixation.

### Résumé de l'invention

Une idée à la base de l'invention est de fournir un dispositif de refroidissement simple, rapide et économique à produire.

Selon un mode de réalisation, l'invention fournit un dispositif de refroidissement pour un module de puissance comportant une partie de circulation dans laquelle un fluide de refroidissement est destiné à circuler et une partie de fixation pour fixer le module de puissance sur la partie de circulation, dans lequel:
- la partie de circulation comporte un empilement de plaques de métal comprenant une première plaque adaptée à recevoir le module de puissance et une pluralité de plaques intermédiaires comportant des évidements ménageant des canaux destinés à la circulation du fluide de refroidissement,
- la partie de fixation comporte un couvercle pour maintenir le module de puissance, adapté à plaquer le module de puissance contre la première plaque de l'empilement, et au moins un organe de fixation comportant un filetage, le couvercle étant muni d'un orifice de passage dudit organe de fixation, cet orifice de passage étant adapté à être positionné en regard d'une ouverture d'accueil de la partie de circulation, pour la fixation de la partie de fixation sur la partie de circulation au moyen dudit organe de fixation,
ladite ouverture d'accueil de la partie de circulation étant délimitée par un trou central d'un insert fileté qui est destiné à coopérer avec le filetage de l'organe de fixation et qui est fixé à au moins une des plaques de métal de l'empilement, une pluralité de plaques de métal de l'empilement étant percées chacune d'une ouverture de manière à ce que ces ouvertures délimitent ensemble un logement dans lequel est inséré l'insert fileté.

Grâce à ces caractéristiques, la fabrication du dispositif de refroidissement est rapide et économique. Il n'est pas nécessaire de percer l'ouverture d'accueil dans chaque plaque de métal, elles peuvent être percées en une seule fois. En outre, il n'est pas nécessaire de fileter l'ouverture d'accueil puisque celle-ci est délimitée par le trou de l'insert fileté.

Selon un mode de réalisation, l'empilement de plaques de métal comporte une plaque de fermeture qui ferme le logement à l'opposé de la première plaque.

Grâce à cette caractéristiques, la fabrication du dispositif de refroidissement est rapide et ne produit pas de poussières ou de particules rejetées dans l'environnement du dispositif de refroidissement. En effet, les poussières ou particules produites par le vissage de la vis de fixation dans l'ouverture d'accueil sont recueillies dans le logement fermé par la plaque de fermeture et non rejetées à l'extérieur du dispositif de refroidissement. En outre, cela est obtenu sans ajout de pièce supplémentaire en plus des plaques de l'empilement.

Selon un mode de réalisation, la plaque de fermeture qui obture le logement est plane et s'étend parallèlement aux autres plaques de métal de l'empilement.

Selon un mode de réalisation, le logement comporte au moins un épaulement et l'insert fileté est un écrou serti.

Selon un mode de réalisation, le logement comporte au moins deux épaulements, l'écrou serti comporte une tête qui est en appui contre l'un des épaulements et un bourrelet de sertissage en appui contre un autre des épaulements.

Selon un mode de réalisation, l'insert fileté est entièrement logé dans ledit logement.

Selon un mode de réalisation, chacune des plaques de l'empilement est réalisée en aluminium.

Selon un mode de réalisation, le couvercle de la partie de fixation est moulé.

Selon un mode de réalisation, le couvercle de la partie de fixation comprend une plaquette d'appui destinée à plaquer le module de puissance contre la première plaque de l'empilement et au moins un bras à l'extrémité duquel est ménagé l'orifice de passage de l'organe de fixation.

Selon un mode de réalisation, l'organe de fixation est une vis filetée.

L'invention fournit également un ensemble de puissance, comportant un module de puissance et un dispositif de refroidissement selon l'une des revendications précédentes, le module de puissance étant disposé entre la partie de circulation et la partie de fixation du dispositif de refroidissement, plaqué contre la première plaque de l'empilement par la partie de fixation.

### Brève description des figures

L'invention sera mieux comprise, et d'autres buts, détails, caractéristiques et avantages de celle-ci apparaîtront plus clairement au cours de la description suivante de plusieurs modes de réalisation particuliers de l'invention, donnés uniquement à titre illustratif et non limitatif, en référence aux dessins annexés.
La figure 1 représente schématiquement une vue en coupe d'une partie de circulation d'un ensemble de puissance d'un dispositif de refroidissement.
La figure 2 représente schématiquement une vue agrandie d'un détail de la figure 1.
La figure 3 est une représentation schématique en perspective avant d'une partie de fixation du dispositif de refroidissement et des modules de puissance associés.
La figure 4 est une représentation schématique en perspective avant de l'ensemble de la figure 1.
La figure 5 est une représentation schématique en perspective arrière de l'ensemble de la figure 1.

### Description des modes de réalisation

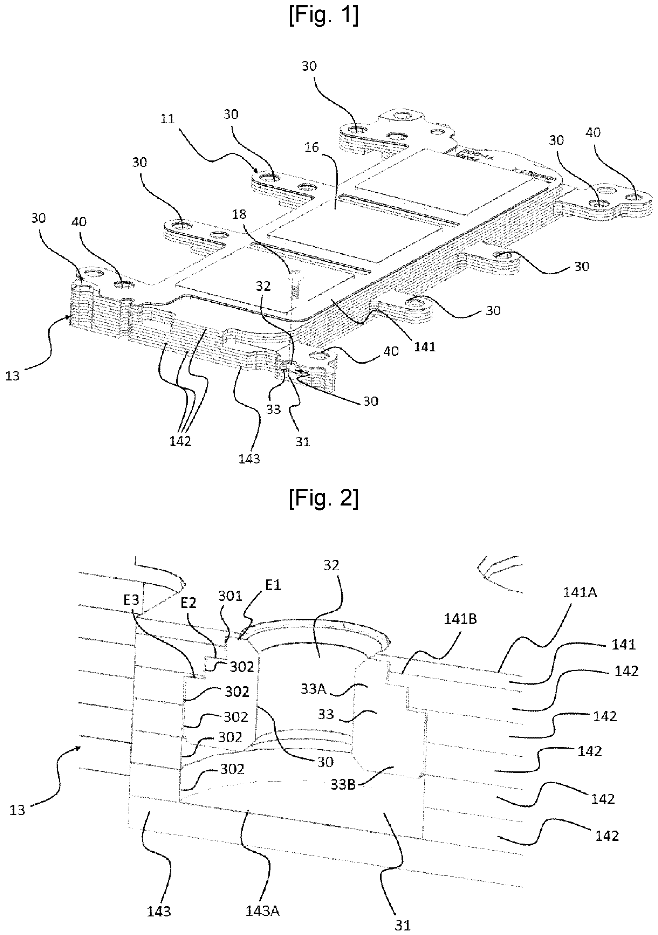

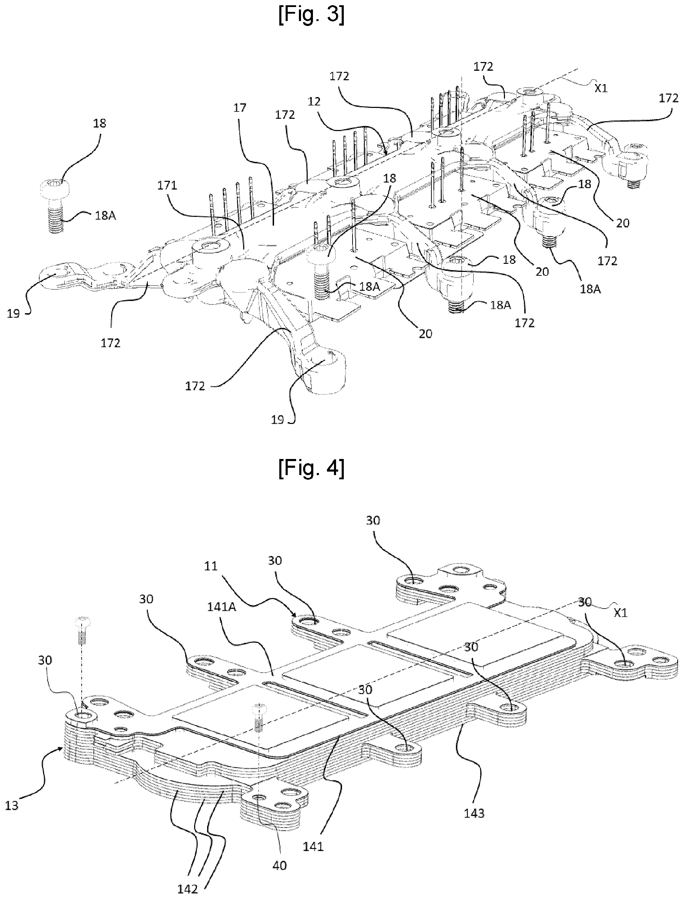

On a représenté sur les figures 1, 4 et 5 une partie de circulation 11 d'un dispositif de refroidissement. Le dispositif de refroidissement comporte une partie de circulation 11 dans laquelle un fluide de refroidissement est destiné à circuler (figures 1, 4 et 5) et une partie de fixation 12 pour fixer le module de puissance 20 sur la partie de circulation 11 (figure 3).

La figure 3 montre également trois modules de puissance 20. Les modules de puissance 20 sont typiquement des composants agencés pour la conversion d'énergie électrique de courant continu en courant alternatif ou vice versa. Ils sont ainsi destinés à former un onduleur, notamment pour un véhicule électrique, c'est-à dire un dispositif agencé pour convertir le courant continu délivré par une batterie électrique en un en courant alternatif pour alimenter une machine électrique à courant alternatif et vice-versa.

Le dispositif de refroidissement décrit ci-après fait partie d'un ensemble de puissance comportant en outre au moins un module de puissance, le module de puissance étant disposé entre la partie de circulation et la partie de fixation du dispositif de refroidissement, plaqué contre la première plaque de l'empilement par la partie de fixation, comme cela sera décrit plus en détails ultérieurement. Il est prévu ici trois modules de puissance 20.

Chaque module de puissance 20 se présente sous la forme d'un bloc de forme globalement parallélépipédique aplatie. Les trois modules de puissance 20 sont ici disposés côte à côte, alignés le long d'une direction longitudinale X1 du dispositif de refroidissement (figure 3). Le dispositif de refroidissement présente ici une forme allongée selon cette direction longitudinale X1.

La partie de circulation 11 comporte un empilement 13 de plaques de métal 14 qui comprend une première plaque 141 adaptée à recevoir le module de puissance 20, c'est-à dire comprenant une découpe correspondant à la forme du module de puissance 20. L'empilement 13 de plaques de métal 14 comprend également une pluralité de plaques intermédiaires 142 comportant des évidements 15 ménageant des canaux destinés à la circulation du fluide de refroidissement (figure 3).

Le fluide de refroidissement est un liquide, par exemple à base d'eau avec des additifs, par exemple à base de glycol ou tout autre liquide de refroidissement utilisé dans l'automobile.

Chacune des plaques de l'empilement est réalisée en aluminium. Ce matériau assure des échanges thermiques efficaces avec le fluide de refroidissement.

L'empilement 13 de plaques de métal 14 de la partie de circulation 11 comporte en outre une dernière plaque 143 disposée à l'opposé de la première plaque 141 dans l'empilement.

La première plaque 141, les plaques intermédiaires 142 et la dernière plaque 143 sont planes et comportent deux faces principales parallèles reliées par une tranche périphérique.

Une face avant 141A de la première plaque 141 reçoit chaque module de puissance 20. Une face arrière 141B de la première plaque 141 opposée à sa face avant est appliquée contre les plaques de métal intermédiaires 142 (figure 1).

Les faces principales des plaques de métal intermédiaires 142 sont accolées les unes contre les autres.

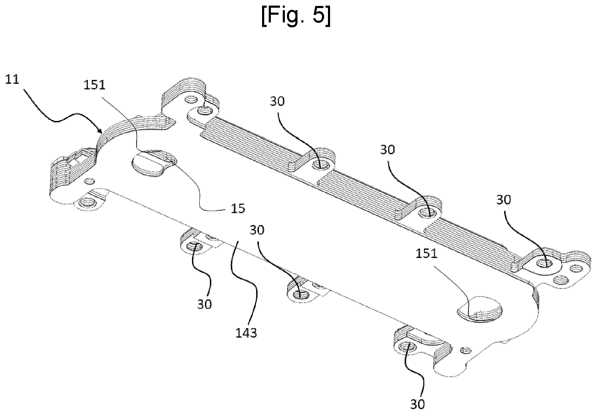

Les évidements 15 (figure 5) de chaque couple de deux plaques intermédiaires 142 voisines juxtaposées dans l'empilement de plaques intermédiaires 142 sont en communication au moins partielle. Des canaux sont ainsi ménagés dans l'empilement de plaques de métal 14 par la mise en communication de ces évidements 15. Ces canaux débouchent à l'extérieur de la partie de circulation 11, de manière à pouvoir être reliés à un système de circulation de fluide de refroidissement. Le système de circulation de fluide de refroidissement injecte dans les canaux ainsi formés un fluide de refroidissement qui circule dans les canaux pour dissiper une partie de la chaleur contenue dans la partie de circulation et ainsi refroidir celle-ci.

La dernière plaque 143 présente également une face avant plane 143A contre laquelle est positionnée la face arrière de la plaque intermédiaire 142 de l'empilement 13 adjacente à la dernière plaque 143 (figure 2).

La dernière plaque 143 ferme au moins partiellement les canaux. Elle peut comporter des ouvertures 151 (figure 5) permettant de relier les canaux au système de circulation de fluide (non représenté).

La partie de fixation 12 comporte un couvercle 17 pour maintenir chaque module de puissance 20. Le couvercle 17 est adapté à plaquer chaque module de puissance 20 contre la première plaque 141 de l'empilement 13 (figure 3).

La partie de fixation 12 comporte en outre au moins un organe de fixation 18 (figure 3) comportant un filetage.

Le couvercle 17 est muni d'au moins un orifice de passage 19 dudit organe de fixation 18.

Plus précisément, il est prévu ici huit organes de fixation et huit orifices de passage correspondants.

Le couvercle 17 de la partie de fixation 12 est par exemple moulé en métal, tel qu'en aluminium.

Chaque orifice de passage 19 est adapté à être positionné en regard d'une ouverture d'accueil 30 de la partie de circulation 11, pour la fixation de la partie de fixation 12 sur la partie de circulation 11 au moyen dudit organe de fixation 18.

En pratique, le couvercle 17 présente ici la forme d'un cavalier avec une plaquette centrale d'appui 171 et une pluralité de bras latéraux 172 qui s'étendent à partir de la plaquette centrale d'appui 171.

La plaquette centrale d'appui 171 s'étend le long de la direction longitudinale X1 du dispositif de refroidissement 10.

La plaquette centrale d'appui 171 est destinée à plaquer le module de puissance 20 contre la partie de circulation 11 du dispositif de refroidissement 10.

Lorsque le couvercle 17 est en place sur la partie de circulation 11, la plaquette centrale d'appui 171 s'étend à distance de la première plaque 141, globalement parallèlement à sa face avant 141A. Un logement de réception de chaque module de puissance 20 est ainsi ménagé entre la face avant 141A de la première plaque 141 et la plaquette centrale d'appui 171 du couvercle 17.

L'écart entre la plaquette centrale d'appui 171 et la face avant 141A de la première plaque 141 de l'empilement 13 lorsque la partie de fixation 12 est fixée sur la partie de circulation 11 est déterminé pour que chaque module de puissance 20 soit plaqué contre la face avant 141A de la première plaque 141 lorsque la partie de fixation 12 est fixée sur la partie de circulation 11.

Chaque bras latéral 172 de la partie de fixation 170 s'étend à partir de la plaquette centrale 171 jusqu'à la face avant 141A de la première plaque 141. La forme des bras latéraux impose l'écart décrit précédemment entre la plaquette centrale d'appui 171 et la face avant 141A de la première plaque 141 de l'empilement 13 lorsque la partie de fixation 12 est fixée sur la partie de circulation 11.

Les bras latéraux 172 du couvercle 17 s'étendent de part et d'autre de la plaquette centrale d'appui 171. Une partie d'entre eux s'étend entre les modules de puissance 20 et de part et d'autre de ceux-ci. Les bras latéraux qui s'étendent entre les modules de puissance 20 s'étendent perpendiculairement à l'axe longitudinal X1. Le couvercle 17 peut comprendre également d'autres bras latéraux 172 qui s'étendent avec un angle non nul autre que 90° par rapport à la plaquette centrale 171. Il s'agit notamment des bras latéraux 172 qui s'étendent à chaque extrémité de la plaquette centrale 171 et bloquent les modules de puissance aux extrémités longitudinales du dispositif.

Les bras latéraux 172 séparent deux à deux les modules de puissance 20 le long de la direction longitudinale X1 et bloquent tout mouvement des modules de puissance le long de cette direction longitudinale X1 (figure 3).

Le couvercle comprend ici à cet effet huit bras latéraux 172 qui encadrent et séparent les trois modules de puissance 20.

Il est prévu un orifice de passage 19 de l'organe de fixation 18 à l'extrémité de chaque bras latéral 172.

L'ouverture d'accueil 30 de la partie de circulation 11 correspondant à chaque orifice de passage 19 de la partie de fixation 12 est percée à travers une pluralité de plaques 141, 142 de métal dudit empilement 13.

L'empilement 13 comporte en outre d'autres ouvertures 40 adaptées à accueillir un élément de fixation fileté tel qu'une vis de fixation.

L'organe de fixation 18 est par exemple une vis filetée comportant un filetage 18A (figure 2) destiné à coopérer avec la vis filetée.

En variante encore, l'organe de fixation peut comprendre une partie d'encliquetage coopérant avec une ouverture ou un système de sertissage ou de rivetage.

Plus précisément, ladite ouverture d'accueil 30 de la partie de circulation 11 est délimitée par un trou central 32 d'un insert fileté 33 qui est destiné à coopérer avec le filetage 18A de l'organe de fixation 18 et qui est fixé à au moins une des plaques de métal de l'empilement 13.

En pratique, chaque plaque de métal 141, 142 d'une pluralité de plaques de métal 141, 142 de l'empilement 13 est percée d'une ouverture 301, 302 de manière à ce que ces ouvertures délimitent ensemble un logement 31 dans lequel est inséré l'insert fileté 33.

L'insert fileté 33 peut notamment être un écrou, et avantageusement un écrou serti.

Cet écrou présente ici un contour externe circulaire. Les ouvertures 301, 302 des plaques de métal 141, 142 sont également circulaires et le logement 31 formé est sensiblement cylindrique.

Plus précisément, ici, le logement 31 comporte au moins un épaulement, par exemple deux ou trois épaulements E1, E2, E3. Chaque épaulement correspond à une augmentation brusque du diamètre du logement 31 formé par les ouvertures 301, 302 des plaques de métal 141, 142 selon la direction orientée depuis la première plaque 141 vers la dernière plaque 143. Le ou les épaulements E1, E2, E3 sont disposés à proximité de l'embouchure de l'ouverture d'accueil 30, c'est-à-dire à proximité de la face avant 141A de la première plaque 141. Sur l'exemple représenté sur la figure 2, le logement 31 comprend trois épaulements E1, E2, E3.

L'insert fileté est ici serti dans le logement 31. Il est serti à proximité de la face avant 141A de la première plaque 141, au niveau des épaulements E1, E2, E3 (figure 2).

L'écrou serti comporte une tête 33A qui est en appui contre l'un des épaulements E1, E2 et un bourrelet de sertissage 33B en appui contre un autre des épaulements E3.

L'écrou est ici entièrement logé dans le logement 31. Une face avant de l'écrou s'étend très légèrement en retrait de la face avant 141A de la première plaque 141. En variante, la face avant de l'écrou affleure la face avant 141A de la première plaque 141. En variante encore, l'insert fileté peut être seulement partiellement logé dans l'ouverture d'accueil. Il peut alors dépasser d'un côté et/ou de l'autre de l'empilement 13.

L'ouverture d'accueil 30 peut traverser entièrement l'empilement 13 ou être borgne.

Dans ce dernier cas, l'ouverture d'accueil 30 est fermée par exemple par une plaque de fermeture de l'empilement 13. Il s'agit par exemple de la dernière plaque 143 de l'empilement 13 (figure 2).

En variante, la plaque de fermeture peut être l'une des plaques intermédiaires de l'empilement.

La plaque de fermeture qui obture le logement est plane et s'étend parallèlement aux autres plaques de métal 141, 142, 143 de l'empilement.

La partie de la plaque de fermeture qui ne s'étend pas en face de l'ouverture d'accueil 30 est appliquée contre la face arrière de la plaque intermédiaire adjacente à la plaque de fermeture.

Lorsque l'ouverture d'accueil 30 de la partie de circulation 11 dans laquelle est fixée l'organe de fixation 18 est fermée, les poussières ou particules générées par l'introduction de l'organe de fixation 18 dans l'ouverture d'accueil 30 ne peuvent pas s'échapper de la partie de circulation 11 du dispositif de refroidissement. Ces poussières ou particules sont retenues à l'intérieur du logement 31. Ainsi, l'environnement du dispositif de refroidissement reste propre, exempt de poussières ou particules.

En outre, cela est réalisé de manière particulièrement simple, rapide et économique. En effet, aucun élément additionnel n'est utilisé pour retenir les poussières et particules. Le logement est formé par l'une des plaques de métal de l'empilement de plaques de métal 14 de la partie de circulation 11.

En particulier, selon un mode de réalisation une partie d'un dispositif de refroidissement est fabriqué selon les étapes suivantes :
- on assemble une pluralité de plaques de métal 14 dudit empilement 13, par exemple par brasure,
- on perce les ouvertures 301, 302 de chaque plaque de métal de l'empilement 13,
- on sertit l'écrou dans le logement formé par lesdites ouvertures 301, 302.

En outre, d'autres ouvertures d'accueil d'une vis de fixation peuvent être obtenues de cette façon.

Bien que l'invention ait été décrite en liaison avec plusieurs modes de réalisation particuliers, il est bien évident qu'elle n'y est nullement limitée et qu'elle comprend tous les équivalents techniques des moyens décrits ainsi que leurs combinaisons si celles-ci entrent dans le cadre de l'invention.

On a décrit ici un ensemble de puissance comprenant un dispositif de refroidissement et trois modules de puissance. L'ensemble de puissance peut également comprendre un dispositif de refroidissement et au moins un module de puissance. Il comprend de préférence un dispositif de refroidissement et entre un et un nombre N de modules de puissance, N étant un nombre entier. Par exemple N est égal à 3 ou 5 ou 6 ou 10. Chaque module de puissance peut être formé d'un module comprenant un ensemble de composants électroniques dont des transistors, par exemple des transistors MOS, formant des interrupteurs. Alternativement, un module de puissance peut être composé d'un composant discret tel qu'un transistor IGBT. Alternativement encore, un module de puissance peut être remplacé par un module d'excitation, notamment un module d'excitation d'une bobine du rotor d'une machine électrique tournante.

L'usage du verbe « comporter », « comprendre » ou « inclure » et de ses formes conjuguées n'exclut pas la présence d'autres éléments ou d'autres étapes que ceux énoncés dans une revendication.

Dans les revendications, tout signe de référence entre parenthèses ne saurait être interprété comme une limitation de la revendication.

## Revendications

1. Dispositif de refroidissement (10) pour un module de puissance (20) comportant une partie de circulation (11) dans laquelle un fluide de refroidissement est destiné à circuler et une partie de fixation (12) pour fixer le module de puissance sur la partie de circulation, dans lequel:
- la partie de circulation comporte un empilement (13) de plaques de métal (141, 142, 143) comprenant une première plaque (141) adaptée à recevoir le module de puissance (20) et une pluralité de plaques intermédiaires (142) comportant des évidements (15) ménageant des canaux (15A) destinés à la circulation du fluide de refroidissement,
- la partie de fixation (12) comporte un couvercle (17) pour maintenir le module de puissance (20), adapté à plaquer le module de puissance (20) contre la première plaque (141) de l'empilement (13), et au moins un organe de fixation (18) comportant un filetage, le couvercle (17) étant muni d'un orifice de passage (19) dudit organe de fixation (18), cet orifice de passage (19) étant adapté à être positionné en regard d'une ouverture d'accueil (30) de la partie de circulation (11), pour la fixation de la partie de fixation (12) sur la partie de circulation (11) au moyen dudit organe de fixation (18),
ladite ouverture d'accueil (30) de la partie de circulation (11) étant délimitée par un trou central (32) d'un insert fileté (33) qui est destiné à coopérer avec le filetage de l'organe de fixation et qui est fixé à au moins une des plaques de métal (141, 142, 143) de l'empilement (13), une pluralité de plaques de métal (141, 142) de l'empilement (13) étant percées chacune d'une ouverture (301, 302) de manière à ce que ces ouvertures délimitent ensemble un logement (31) dans lequel est inséré l'insert fileté (33).

2. Dispositif de refroidissement (10) selon la revendication 1, dans lequel l'empilement (13) de plaques de métal (141, 142, 143) comporte une plaque de fermeture (143) qui ferme le logement (31) à l'opposé de la première plaque (141).

3. Dispositif de refroidissement (10) selon la revendication 2, dans lequel la plaque de fermeture (143) qui obture le logement (31) est plane et s'étend parallèlement aux autres plaques de métal (14) de l'empilement (13).

4. Dispositif de refroidissement (10) selon l'une des revendications 1 à 3, dans lequel le logement (31) comporte au moins un épaulement (E1, E2, E3) et dans lequel l'insert fileté (33) est un écrou serti.

5. Dispositif de refroidissement (10) selon la revendication 4, dans lequel le logement comporte au moins deux épaulements (E1, E2), l'écrou serti comporte une tête (33A) qui est en appui contre l'un des épaulements (E1, E2) et un bourrelet de sertissage (33B) en appui contre un autre des épaulements (E3).

6. Dispositif de refroidissement (10) selon la revendication 5 dans lequel l'insert fileté (33) est entièrement logé dans ledit logement (31).

7. Dispositif de refroidissement (10) selon l'une des revendications 1 à 6, dans lequel chacune des plaques de métal (14) de l'empilement (13) est réalisée en aluminium.

8. Dispositif de refroidissement (10) selon l'une des revendications 1 à 7, dans lequel le couvercle (17) de la partie de fixation (12) est moulé.

9. Dispositif de refroidissement (10) selon l'une des revendications 1 à 8, dans lequel le couvercle (17) de la partie de fixation (11) comprend une plaquette d'appui (171) destinée à plaquer le module de puissance contre la première plaque de l'empilement et au moins un bras (172) à l'extrémité duquel est ménagé l'orifice de passage (19) de l'organe de fixation (18).

10. Dispositif de refroidissement selon l'une des revendications 1 à 9, dans lequel l'organe de fixation (18) est une vis filetée.

11. Ensemble de puissance, comportant un module de puissance (20) et un dispositif de refroidissement (10) selon l'une des revendications précédentes, le module de puissance (20) étant disposé entre la partie de circulation (11) et la partie de fixation (12) du dispositif de refroidissement (10), plaqué contre la première plaque (141) de l'empilement (13) par la partie de fixation (12).
